# EUROPÄISCHE PATENTANMELDUNG

(11) **EP 1 357 387 A1**
(43) Veröffentlichungstag der Anmeldung: **29.10.2003**
(21) Anmeldenummer: 02008956.1
(22) Anmeldetag: 22.04.2002
(51) Int. Cl.: G01R 31/3185

(54) **Partial-BIST mit Erfassung der Verbindungen zwischen einzelnen Blöcken**

(71) Anmelder: SIEMENS AKTIENGESELLSCHAFT, 80333 München (DE)
(72) Erfinder: Ghameshlu, Majid, 1110 Wiem (AT); Krause, Karlheinz, 82152 Planegg (DE); Taucher, Herbert, 2340 Moedling (AT)

(57) **Zusammenfassung**

Bei einem elektronischen Baustein ist es wünschenswert den Build-In-Self-Test (BIST) so zu implementieren, dass einerseits eine höchstmögliche Testabdeckung erreicht wird, aber andererseits der Test einfach zu realisieren und die BIST-Dauer gering ist. Hierbei darf der Overhead bzw. der Aufwand für den BIST ein vernünftiges Maß nicht überschreiten. Dies wird dadurch erreicht, dass bei einem Baustein mit in funktionale Blöcke zusammengefasste integrierte Schaltkreise, wobei die funktionalen Blöcke untereinander Verbindungen und eine jeweilige Restlogik aufweisen, zuerst die Restlogiken der funktionalen Blöcke durch Eingabe von Testdaten in die Restlogiken getestet sowie einer erste Signatur für jeden Block ausgegeben wird, und anschließend die Verbindungen zwischen den Blöcken untereinander durch Übermittlung von Testdaten über die Verbindungen getestet und eine zweite Signatur ausgegeben wird.

## Beschreibung

Die Erfindung bezieht sich auf ein Verfahren und eine Vorrichtung zum Testen eines elektronischen Bausteins mit in funktionale Blöcke zusammengefaßte integrierte Schaltkreise, wobei die funktionalen Blöcke untereinander Verbindungen und eine jeweilige Restlogik aufweisen.

Elektronische Bausteine dieser Art werden häufig als Applications-Specific-Integrated-Circuits (ASICs) ausgebildet. Mit ASICs bezeichnet man eine Anordnung von logischen Gatter- sowie Speicherschaltungen auf einem einzelnen Siliziumwafer. ASICs sind eine Ansammlung von Schaltungen mit einfachen Funktionen, wie Flip-Flops, Inverter, NANDs und NORs, sowie von komplexeren Strukturen wie Speicheranordnungen, Addierern, Zählern und Phasenregelschleifen. Die verschiedenen Schaltungen werden in einem ASIC kombiniert, um eine bestimmte Anwendung durchzuführen. Hierbei werden ASICs in einer Vielzahl von Produkten, wie z.B. Konsumprodukten, wie Videospielen, digitale Kameras, in Fahrzeugen und PCs, sowie in Highend- und Technologieprodukten, wie Workstations und Supercomputern, eingesetzt.

Um die fehlerfreie Funktion eines ASICs zu überprüfen sind verschiedene "Design-for-Test" (DFT-Verfahren) bekannt. Der Vorteil von DFT-Verfahren liegt darin, dass bereits bei der Konstruktion des Chips Schaltungselemente eingefügt werden, die ein späteres scan-basiertes Testes ermöglicht, die Anzahl der benötigten Testpunkte auf dem Board des ASICs reduziert und zugleich das Problem von nicht vorhandenen Zugriffspunkten auf dem Chip umgeht

Eines dieser Verfahren ist der sogenannten "Build-In-Self-Test" (BIST). Der BIST sieht BIST-Eingangszellen vor, über die ein Testvektor in die ASIC-Logik eingegeben wird, um die Schaltungen innerhalb der Logik entlang von Scan-Pfaden zu testen. Die Ausgaben der durch den Testvektor stimulierten Logik gelangen in BIST-Ausgangszellen, die einen Test-Antwort-Auswerter (TAA) für das BIST-Verfahren darstellen und die Testsignatur bzw. Signatur für die Logik bilden. Die Signaturen können nachfolgend analysiert werden, z.B. durch Vergleich mit einer theoretischen, erwarteten Signatur, um gegebenenfalls vorhandene Fehler in der Logik aufzuzeigen.

Generell kann die Logik eines ASICs mehrere Logikblöcke umfassen, die jeweils Teilaufgaben des Gesamt-ASICs übernehmen. Die verbreiteten BIST-Methoden für ASICs mit mehreren Blöcken gliedern sich grundsätzlich in zwei Kategorien, wobei beide Methoden die im ASIC eingebauten Scan-Pfade mitbenutzen.
(A) Gesamt-BIST:
   Bei dem sogenannten Gesamt-BIST werden alle für den BIST relevanten Blöcke der Logik mit einer Prozedur, die sich über die gesamte Logik hindurchzieht, getestet, und als Ergebnis steht eine Signatur für den gesamten ASIC zur Verfügung. Ausgenommen sind dabei lediglich die ASICinternen RAMs und ROMs oder andere Unterblöcke, die rechtlich geschützt sind, und dem BIST nicht zur Verfügung stehen. Hierbei ergeben sich die folgenden Vorteile: Neben den relevanten Blöcken werden auch die Verbindungen zwischen diesen getestet. Ebenso muss lediglich ein BIST-Controller für den gesamten ASIC realisiert werden. Ein Nachteil des Gesamt-BIST Verfahrens ist jedoch, dass sich dadurch, dass die Prozedur sich über die gesamte Logik erstreckt, der Ablauf kompliziert und nicht parallelisierbar ist. Weiterhin muss für das Gesamt-BIST-Verfahren ein Test-Muster-Generator (TMG) und ein Test-Antwort-Auswerter (TAA) vorgesehen werden, die alle funktionalen Eingänge und Ausgänge, sowie die vielen, eigens für den BIST geschaffene Teil-Scanketten einschließt. Dies stellt einen hohen Aufwand dar. Darüber hinaus müssten alle Eingänge und Ausgänge der Teil-Scanketten (bestehend auf 50 bis 100 Flip-Flops) Verdrahtungen zu den rund um den ASIC realisierten TMG und TAA aufweisen.
(B) Partial-BIST
   Bei dem Partial-BIST werden alle Blöcke parallel, aber voneinander unabhängig getestet. Die daraus resultierenden Signaturen der einzelnen Blöcke werden dann zu einer entsprechenden Gesamtsignatur des ASICs zusammengefaßt. Vorteilhafterweise ist der Ablauf des Partial-BISTs parallelisierbar, d.h. die Testzeiten verkürzen sich, und das Design ist einfacher als beim Gesamt-BIST, was den Aufwand verringert. Beim Partial-BIST ergeben sich jedoch die folgenden Nachteile: Jeder Block wird von einem eigenen TMG und TAA umgeben. Dies führt zu einem großen Overhead und zu Veränderungen der Timingverhältnisse der funktionalen Eingänge und Ausgänge. Weiterhin werden die Verbindungen zwischen den Blöcken und von/zu den ASIC-Pins nicht getestet. Darüber hinaus besteht die BIST-Logik aus einem zentralen und vielen lokalen Controllern, was die Zahl der zu addierenden BIST-Elemente nachteilig erhöht. Der Partial-Bist wird beispielsweise in "Essentials of electronic testing for digital, memory and mixed-signal VLSI circuits", Michael L. Bushnell et al, Kluwer Acadamic Publishers, ISBN 0-7923-7991-8, beschrieben.

Die Anforderungen bezüglich des BISTs in elektronischen Systemen und damit die Auforderungen an die Hardware, insbesondere an kundenspezifische elektronische ASIC-Bausteine, sind in den letzten Jahren sehr stark gestiegen.

Der vorliegenden Erfindung liegt die Aufgabe zugrunde, einen Baustein und ein BIST-Verfahren vorzusehen, wobei einerseits eine höchstmögliche Testabdeckung erreicht wird, aber andererseits der Test einfach zu realisieren und die BIST-Dauer gering ist. Hierbei darf der Overhead bzw. der Aufwand für den BIST ein vernünftiges Maß nicht überschreiten.

Diese Aufgabe wird durch ein Verfahren zum Testen eines elektronischen Bausteins gemäß Anspruch 1 gelöst, und zwar durch Testen der Restlogiken der funktionalen Blöcke durch Eingabe von Testdaten in die Restlogik und ausgeben einer ersten Signatur für jeden Block, und anschließendes Testen der Verbindungen zwischen den Blöcken untereinander mittels Übermittlung von Testdaten über die Verbindungen und Ausgeben einer zweiten Signatur.

Durch das zweiteilige Testen des ASICs, d.h. Testen aller Blöcke parallel (Block-BIST) und nachfolgendes Testen der Verbindung zwischen den Blöcken (Verbindungs-BIST), ergeben sich folgende Vorteile: Der Aufwand für das "Design-for-Test" ist durch den parallelen Block-BIST (erster Schritt) geringer. Die Testabdeckung durch das erfindungsgemäße BIST-Verfahren ist höher, da die Verbindungen zwischen den Blöcken miterfaßt werden (zweiter Schritt).

Bei einer vorteilhaften Ausführungsform werden die ersten und zweiten Signaturen bei einem Testcontroller gesammelt und eine Gesamtsignatur wird für den Baustein erzeugt. Hierdurch wird eine Gesamtbewertung des Bausteins trotz des zweiteiligen Testverfahrens möglich.

Bei einer weiteren vorteilhaften Ausführungsform wird das Testen der Restlogiken der jeweiligen Blöcke parallel zueinander durchgeführt. Somit werden die Testzeiten erheblich verkürzt

Gemäß einem weiteren vorteilhaften Aspekt wird das Testen der Verbindungen der jeweiligen Blöcke parallel zueinander durchgeführt um in diesem Schritt des BISTs ebenso die Testzeiten zu verkürzen.

Bei einer anderen vorteilhaften Ausführungsform weist jeder funktionale Block Scan-Ketteneingangs-Flipflops und Scan-Kettenausgangs-Flipflops auf, wobei für das Testen der Restlogiken und das Testen der Verbindungen die Scan-Ketteneingangs-Flipflops und Scan-Kettenausgangs-Flipflops durch einen lokalen Controller jeweils zu einem Schieberegister zusammengeschaltet werden. Hierdurch können die Schieberegister für die Testmustergeneratoren und Testantwortauswerter für das zweiteilige BIST-Verfahren gebildet werden.

Bei einer besonders vorteilhaften Ausgestaltung werden die Scan-Ketteneingangs-Flipflops und Scan-Kettenausgangs-Flipflops jeweils zu einem Linear-Feedback-Shift-Register zusammengeschaltet. Dadurch wird kein externer Testvektorgenerator benötigt um Testvektoren in den Testmustergenerator einzugeben.

Bei einer anderen vorteilhaften Ausgestaltung können die Scan-Ketteneingangs-Flipflops und/oder Scan-Kettenausgangs-Flipflops mit einem Testvektorgenerator gekoppelt werden, um Testdaten für die Schieberegister vorzusehen. Dadurch können zum Beispiel komplexere Testvektoren, die von einem LFSR nicht erzeugt werden können eingeschoben werden. Die Scan-Ketteneingangs-Flipflops und Scan-Kettenausgangs-Flipflops können hierbei durch einen einzelnen, zentralen, globalen Testvektorgenerator versorgt werden, oder jedem funktionalen Block ist ein Testvektorgenerator zugewiesen, der wahlweise, je nach Schritt des Verfahrens entweder mit den Scan-Ketteneingangs-Flipflops oder den Scan-Kettenausgangs-Flipflops gekoppelt wird.

Bei einer weiteren vorteilhaften Ausgestaltung dient für das parallele Testen der Restlogiken die Scan-Ketteneingangs-Flipflops als Testmustergenerator und die Scan-Kettenausgangs-Flipflops als Testantwortauswerter und für das Testen der Verbindungen dienen die Scan-Ketteneingangs-Flipflops als Testantwortauswerter und die Scan-Kettenausgangs-Flipflops als Testmustergenerator. Zusätzlicher Logikaufwand durch mehrfache TMGs und TAAs wird hierdurch vermieden.

Die oben gestellte Aufgabe wird auch durch einen elektronischen Baustein gemäß Anspruch 10 gelöst. Jeder funktionale Block ein erstes und ein zweites Schieberegister aufweist, wobei das erste Schieberegister zum Testen der Restlogik Testdaten bereitstellt, die nach Durchlaufen der Restlogik vom zweiten Schieberegister aufgenommen werden und als erste Signatur vorgesehen werden, und wobei zum Testen der Verbindungen das zweite Schieberegister Testdaten zum Testen der Verbindungen bereitstellt, die von dem ersten Schieberegister nach Durchlaufen der Ausgangs- und Eingangslogik aufgenommen und als zweite Signatur vorgesehen werden.

Die bereits oben bzgl. des erfindungsgemäßen Verfahrens erwähnten Vorteile gelten ebenso bezüglich des erfindungsgemäßen Bausteins. Darüber hinaus ergeben sich weitere Vorteile:

Bei einer besonderen Ausführungsform weist jeder funktionale Block einen lokalen Testcontroller auf, der das erste und das zweite Schieberegister steuert. Der Testcontroller steuert hierbei in beiden Schritten des Verfahrens durch senden des BIST-Modussignals an den TMG und TAA ob die Scan-Ketteneingangs-Flipflops und Scan-Kettenausgangs-Flipflops des TMGs und TAAs Daten übernehmen oder Daten entlang des Schieberegisters schieben.

Bei einer weiteren besonderen Ausgestaltung ist ein globaler Testcontroller mit den lokalen Testcontrollern der funktionalen Blöcke verbunden und sendet ein Startsignal an diese, um ein zentrales Starten des BIST vorzusehen.

Bei einer anderen Ausführungsform wird eine Reset-Logik vorgesehen, die mit den lokalen Testcontrollern der funktionalen Blöcke verbunden ist und ein Reset-Signal an diese sendet, um durch die lokalen Testcontroller ansprechend auf das Reset-Signal die funktionalen Blöcke vor dem Block-BIST und vor dem Verbindungs-BIST zurücksetzten.

Bei einer weiteren besonderen Ausgestaltung weisen die Scan-Ketteneingangs-Flipflops sowohl bereits für die Bausteinfunktion bereits existierende Eingabe-FFs als auch zusätzliche Eingabe-FFs auf. Ebenso weisen die Scan-Kettenausgangs-Flipflops sowohl bereits für die Bausteinfunktion bereits existierende Ausgabe-FFs als auch zusätzliche Ausgabe-FFs auf. Dadurch das die lokalen TMGs und TAAs aus bereits vorhandenen Flip-Flops gebildet werden, wird im erheblichen Maße ein zusätzliche Design- und Bauelementeaufwand für die BIST Implementierung vermieden. Wenn die Zahl der vorhandenen Eingangsflipflops bzw. der Ausgangsflipflops der Anzahl der Scan-Eingängen und -Ausgängen entspricht, müssen sogar keine zusätzlichen Eingabe-FFs und Ausgabe-FFs vorgesehen werden.

Ein Ausführungsbeispiel der Erfindung ist in den Zeichnungen dargestellt und wird im Folgenden näher beschrieben. Es zeigen:
- Fig. 1: eine schematische Darstellung eines Teils eines ASICs gemäß der vorliegenden Erfindung, konfiguriert zur Durchführung des Block-BISTs;
- Fig. 2: eine schematische Darstellung eines erfindungsgemäßen ASICs, wobei die logische Trennung der einzelnen Blöcke während des Block-BISTs illustriert wird;
- Fig. 3: eine schematische Teildarstellung des erfindungsgemäßen ASICs gemäß der vorliegenden Erfindung und ähnlich zu Fig. 1, die das Prinzip des Verbindungs-BISTs darstellt;
- Fig. 4: eine schematische Darstellung eines ASICs gemäß der vorliegenden Erfindung, wobei die Durchführung des Verbindungs-BISTs unter Einbeziehung der ASIC-Pins dargestellt wird;
- Fig. 5: ein Flussdiagramm das den Ablauf des erfingungsgemäßen Verfahrens darstellt.

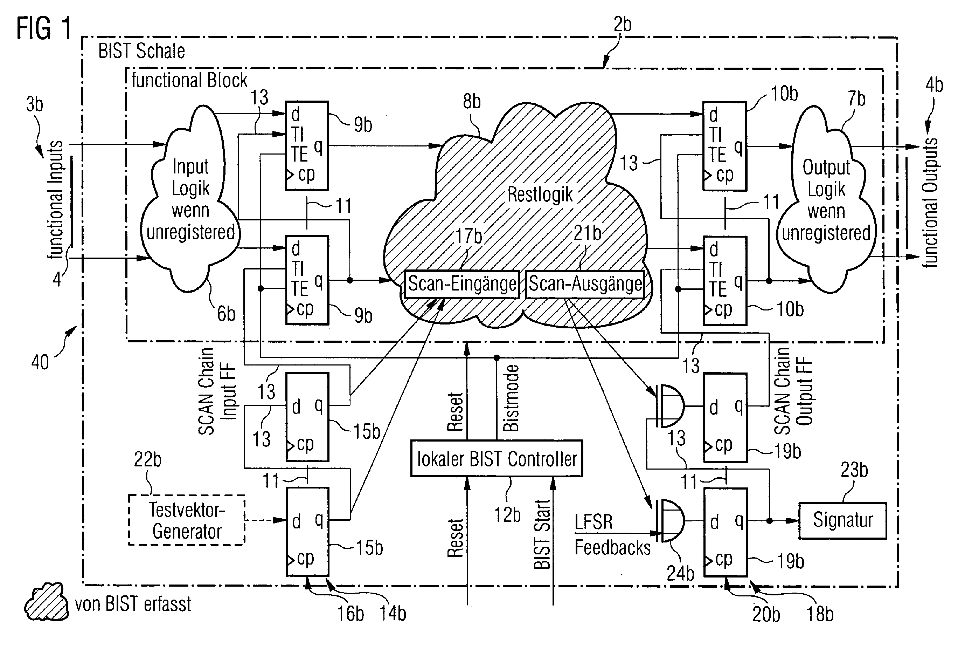

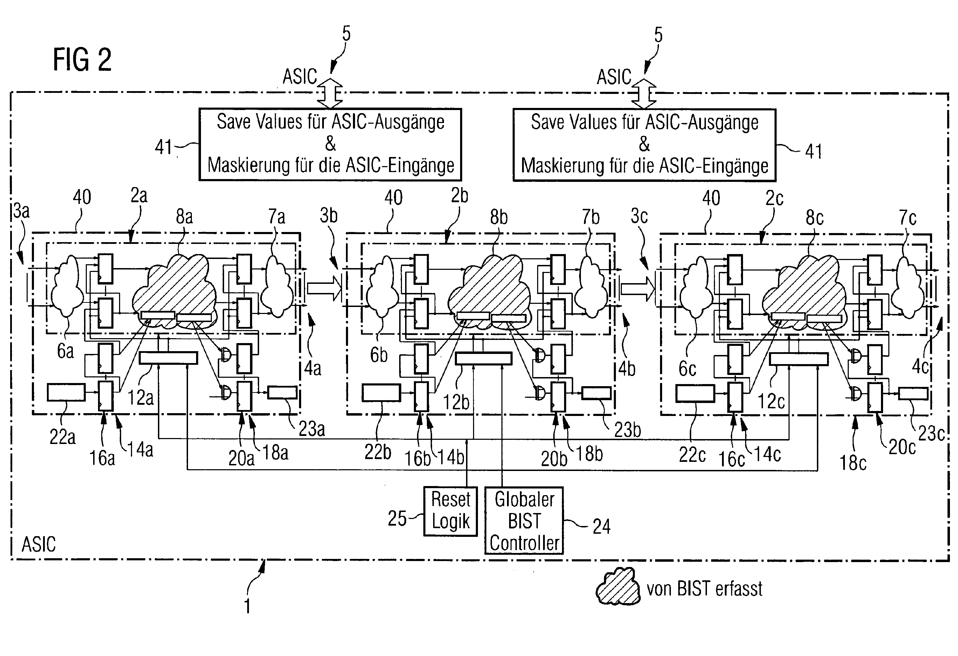

Im Folgenden wird ein Ausführungsbeispiel der vorliegenden Erfindung unter Bezugnahme auf einen Application Specific Integrated Circuit (ASIC) beschrieben. Wie bereits eingangs erwähnt, weist jeder ASIC generell eine anwendungsspezifische Logik auf, die sich je nach Art und Umfang der Anwendung des ASICs in mehrere Logikblöcke unterteilen kann. Figuren 1 und 2 zeigt einen solchen ASIC 1 mit Logikblöcken 2a, 2b, 2c (die im Folgenden als funktionale Blöcke bezeichnet werden). Die funktionalen Blöcke 2a, 2b, 2c sind einem spezifischen Teilaspekt der ASIC-Anwendung zugewiesen. Jeder funktionale Block 2a, 2b, 2c erhält über funktionale Eingänge 3a, 3b, 3c Daten, die blockspezifisch verarbeitet und über funktionale Ausgänge 4a, 4b, 4c nach der Verarbeitung ausgegeben werden.

Die funktionalen Blöcke sind je nach Konstruktion eines spezifischen ASICs mit einem Teil der (oder mit allen) anderen funktionalen Blöcken, sowie mit einem Teil oder allen ASIC-Pins 5 verbunden. Insofern erhalten die funktionalen Eingänge 3a, 3b, 3c im Normalbetrieb des ASICs Daten von ausgewählten anderen Blöcken 2a, 2b, 2c sowie ausgewählten ASIC-Pins 5, und die verarbeiteten Daten der funktionalen Blöcke werden über die funktionalen Ausgänge 4a, 4b, 4c an ausgewählte andere Blöcke 2a, 2b, 2c, sowie ausgewählte ASIC-Pins 5 weitergegeben.

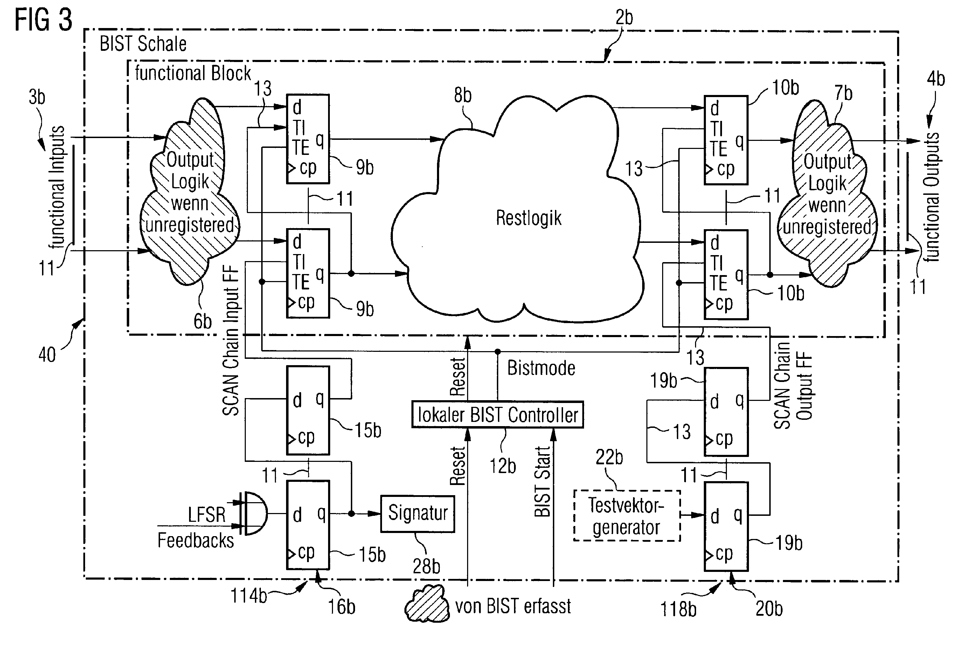

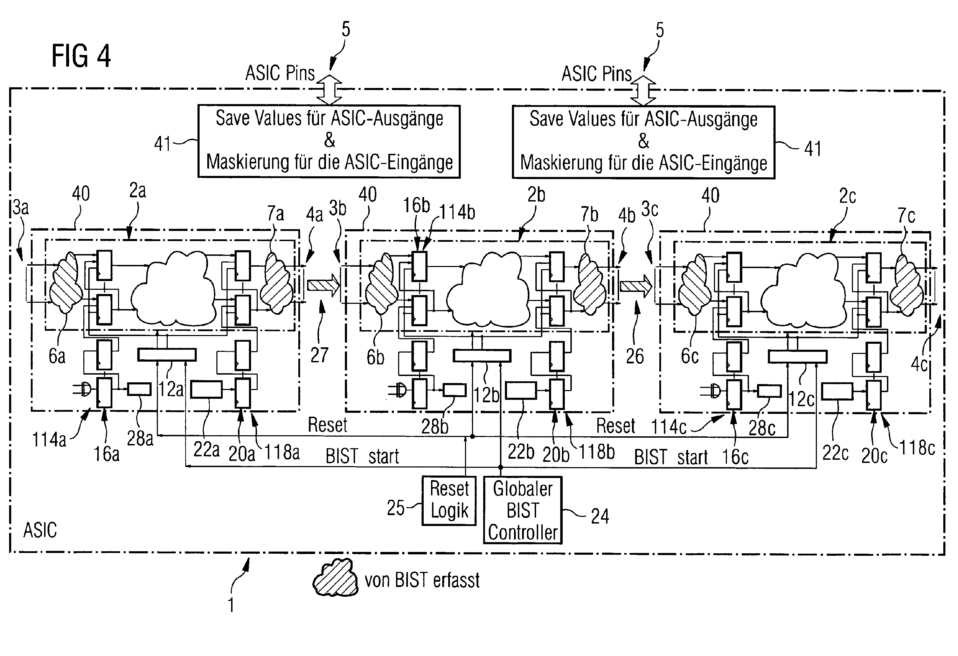

Um bei einem solchen ASIC 1 im Testmodus, d.h. bei der Durchführung des Built-in-Self-Test (BIST), eine größtmögliche Abdeckung zu erzielen, wird erfindungsgemäß ein BIST-Verfahren in zwei Schritten vorgesehen. Der erste Schritt wird als Block-BIST bezeichnet und ist in den Figuren 1 und 2 dargestellt. Im zweiten Schritt des Verfahrens werden dann die Verbindungen zwischen den Blöcken 2a, 2b, 2c in einem als Verbindungs-BIST bezeichneten Schritt, der weiter unten bezüglich der Figuren 3 und 4 beschrieben wird, getestet.

In der Figur 1 ist ein funktionaler Block 2b eingebettet in einer BIST-Schale 40 des ASICs 1 gezeigt. In der BIST-Schale 40 sind alle für die Durchführung des BISTs nötigen blockspezifischen Elemente angeordnet. Der funktionale Block 2b weist neben funktionalen Eingängen 3b und funktionalen Ausgängen 4b eine Eingangslogik 6b, eine Ausgangslogik 7b und eine Restlogik 8b auf. Des weiteren sind zwischen der Eingangslogik 6b und der Restlogik 8b Eingangs-Flip-Flops bzw. Eingangs-FFs 9b und zwischen der Restlogik 8b und der Ausgangslogik 7b Ausgangs-Flip-Flops bzw. Ausgangs-FFs 10b angeordnet.

Im Normalbetrieb gelangen Daten über die funktionalen Eingänge 3b in die Eingangslogik 6b. Die Eingangslogik 6b umfaßt anwendungsspezifische Schaltungen, wie Gatter, Multiplexer, etc., jedoch keine Register bzw. Flip-Flops. Die eingegebenen Daten gelangen dann von Eingangslogik 6b in die Eingangs-FFs 9b, wo sie abgetaktet und in die Restlogik 9b für die Verarbeitung eingegeben werden. Die Restlogik 8b weist alle zur blockspezifischen Verarbeitung nötigen Schaltungselemente auf die nicht der Eingangslogik 6b und Ausgangslogik 75 sind. Nach Verarbeitung durch die Restlogik 8b gelangen die Daten in die Ausgangs-Flip-Flops 10b und werden in die Ausgangslogik 7b weitergegeben. Die Ausgangslogik 7b umfaßt, ähnlich wie die Eingangslogik 6b, anwendungsspezifische Schaltelemente wie Gatter, jedoch keine Register. Von der Ausgangslogik 7b gelangen die Daten über funktionale Ausgänge 4b aus dem funktionalen Block 2b zu anderen Blöcken 2a, 2c des ASICs 1 oder zu den ASIC-Pins 5.

Für den Fertigungstest durch die Hersteller von ASICs sind in den Restlogiken 8a, 8b, 8c Scan-Pfade (Scan Paths) vorgesehen (nicht dargestellt). Für den BIST werden diese Scan-Pfade zu kürzeren Teilketten aufgeteilt um dadurch die BIST-Zeitdauer zu verkürzen. Um im Scan-Betrieb, d.h. die Durchführung des BISTs, Testvektoren für das Durchlaufen der Teil-Scan-Ketten vorzusehen, müssen extra ASIC-Elemente vorgesehen werden. Zum Testen der Restlogik 8b können die Eingangs-Flip-Flops 9b durch Steuerung eines lokalen BIST-Controllers zu einem Schieberegister 14b zusammengeschaltet werden. Im bevorzugten Ausführungsbeispiel ist das Schieberegister 14b ein Linear-Feedback-Shift-Register (LFSR). Das LFSR 14 umfaßt gegebenenfalls jedoch nicht nur die bereits für die Normalfunktion des ASICs 1 existierenden Eingangs-FF 9b sondern auch weitere zusätzliche Eingangs-FFs 15b. Die Eingangs-Flip-Flops 9b und die zusätzlichen Eingangs-Flip-Flops 15b bilden zusammen Scan-Ketten-Eingangs-Flip-Flops 16b und dienen zur Stimulierung von Scan-Eingängen 17b, die sich eingangsseitig in der Restlogik 2b befinden. Die Scan-Eingänge 17b stellen die Eingänge der Teil-Scan-Ketten der Restlogik 2b dar. Die Anzahl der zusätzlichen Eingangs-FFs 15b wird so gewählt, dass eine ausreichende Anzahl von Scan-Ketten-Eingangs-Flip-Flops 16b für die Scan-Eingänge 17b vorhanden sind.

Ebenso sind ausgangsseitig die Ausgangs-Flip-Flops 10b für den BIST über Schiebeleitungen 13 zu einem Schieberegister 18b zusammenschaltbar. Im bevorzugten Ausführungsbeispiel ist das Schieberegister 18b ebenfalls ein Linear-Feedback-Shift-Register (LFSR) 18b zusammenschaltbar. Ähnlich wie zuvor bezüglich des LFSR 14b beschrieben, werden zusätzliche Ausgangs-Flip-Flops 19b vorgesehen, die zusammen mit den für die Funktion bereits vorhandenen Ausgangs-Flip-Flops 10b eine ausreichende Anzahl von Scan-Ketten-Ausgangs-FFs 20b vorsehen. Die Scan-Ketten-Ausgangs-Flip-Flops 20b dienen als Ausgangsregister für Scan-Ausgänge 21b. Die Scan-Ausgänge 21b stellen die Ausgänge der Teil-Scan-Ketten der Restlogik 8b dar.

Während des Block-BISTs werden die Blockgrenzen eingangsseitig durch die Scan-Ketten-Eingangs-FFs 16b und ausgangsseitig durch die Scan-Ketten-Ausgangs-FFs 20b gebildet. Diese können bei entsprechender Beschaltung direkt als Test-Muster-Generator (TMG) oder als Test-Antwort-Auswerter (TAA) während des BISTs dienen.

Wie bereits erwähnt, bilden im bevorzugten Ausführungsbeispiel die durch die Register 9b und 15b bzw. Register 10b und 20b gebildeten Schieberegister 14b, 18b LFSRs. Im Falle dieses Ausführungsbeispiel ist kein zusätzlicher Testvektorgenerator notwendig, da das LFSR eben diese Funktion realisiert.

In einem anderen bevorzugten Ausführungsbeispiel bilden die Scanketteneingangsflipflops 16b und die Scan-Kettenausgangsflipflops 10b lediglich einfache Schieberegister zum Einschieben bzw. Ausschieben von Testdaten und nachfolgendes Eingeben bzw. Aufnehmen der Testdaten. In diesem Ausführungsbeispiel ist ein expliziter Testvektorgenerator 22b für jeden funktionalen Block 2b vorgesehen. Es wäre jedoch auch denkbar, dass lediglich ein globaler Testvektorgenerator vorgesehen ist, der alle funktionalen Blöcke mit Testvektoren versorgt.

Jeder Block weist ferner eine Logik zur Zusammenschaltung der einzelnen Scan-Ketten zu einer langen oder mehreren Ketten für den Herstellertest auf. Des weiteren weist jeder Block-BIST mindestens ein Signatur-Register 23b auf. Im bevorzugten Ausführungsbeispiel weist jeder Block ein erstes und ein zweites Signaturregister auf.

Zum Ablauf des Block-BISTs eines einzelnen Blocks 2b ist Folgendes anzumerken: Der lokale BIST-Controller 12b erhält von einem globalen BIST-Controller 24 (siehe Figur 2) ein BIST-Startsignal, das der BIST-Auslöser ist, sowie von einer Reset-Logik 25 ein Reset-Signal. Der lokale BIST-Controller 12b gibt das Reset-Signal an den funktionalen Block 2b weiter und setzt sämtliche Schaltungselemente des funktionalen Blocks in einen vordefinierten Ausgangszustand. Ferner gibt der lokale BIST-Controller 12b ein BIST-Modussignal an die Scan-Ketten-Eingangs-Flip-Flops 16b und Scan-Ketten-Ausgangs-Flip-Flops 20b um diese zu den LFSR 14b und LFSR 18b zusammenzuschalten. Das BIST-Modussignal bestimmt während des BISTs ob die Schieberegister Daten "schieben" oder "übernehmen". Das LFSR 14b generiert daraufhin Testdaten, die in die jeweiligen Scan-Eingänge 17b eingegeben werden. Nach Durchlaufen der Scan-Ketten gelangen die Testdaten über Scan-Ausgänge 21b in jeweilige Scan-Ketten-Ausgangs-Flip-Flops 20b. Die Scan-Ketten-Ausgangs-Flip-Flops 20b, die das LFSR bilden, dienen hier als Test-Antwort-Auswerter (TAA) und können gegebenenfalls die Daten komprimieren. Der TAA 18b gibt schlußendlich eine Signatur an das Signaturregister 23b aus. Das untere XOR-Symbol 24b in Figur 1 dient sowohl als Einspeisepunkt der maximal periodischen Rückkoppelung des LFSR 18b als auch zur Erfassung der Daten von einem Scan-Ausgang 21b. Das XOR-Symbol 25b koppelt einerseits wiederum einen Scan-Ausgang 21b und die Schieberegisterleitung 13 an einen der zusätzlichen Ausgangs-Flip-Flops 10b.

Auf die oben beschriebene Weise wird sichergestellt, dass alle Flip-Flops des entsprechenden Blocks 2b bei diesem Block-BIST erfaßt werden. Der von dem Block-BIST erfaßte Bereich ist durch den schraffierten Bereich der Resetlogik dargestellt.

Hierbei ist anzumerken das die Linien 11 der Figur 1 für eine Vielzahl der unter und über den Linien 11 angeordneten Elemente steht. So sind in der Figur 1 zwar lediglich zwei Eingangsflipflops 9b dargestellt, die Linie 11 soll jedoch andeuten das hier ggfs. eine mehr als nur zwei Register in der dargestellten Anordnung vorhanden sind. Diese Anmerkung gilt auch für die anderen Figuren dieser Anmeldung.

Bezugnehmend auf Figur 2 wird das Zusammenspiel des blockorientierten Block-BISTs dargestellt. Beispielhaft sind in Figur 2 drei funktionale Blöcke 2a, 2b, 2c dargestellt. Es ist hierbei anzumerken, dass aus Gründen der Übersicht hier lediglich drei Blöcke aufgezeigt sind. Die Lehren der vorliegenden Erfindung sind jedoch ebenso auf einen Baustein mit einer beliebige Anzahl von Blöcken anwendbar. Die Blöcke 2a, 2c weisen jeweils dieselben BIST-relevanten Elemente auf, wie bezüglich Figur 1 beschrieben wurde, auch wenn sich die blockspezifischen Eingangs-, Ausgangs- und Restlogiken 6a, 7a, 8a, 6c, 7c, 8c sich gleichwohl unterscheiden können. Auch die Anzahl der jeweiligen Scan-Ketten-Eingangs-Flip-Flops 16a, 16b, 16c und Scan-Ketten-Ausgangs-Flip-Flops 20a, 20b, 20c können von Block zu Block unterschiedlich sein.

Auf ASIC-Ebene wird beim Block-BIST zunächst von der Resetlogik 25 ein Resetsignal an alle lokalen BIST-Controller 12a, 12b, 12c, gegeben. Außerdem sendet der globale BIST-Controller 24 zentral ein BIST-Startsignal an alle lokalen BIST-Controller 12a, 12b, 12c. Ansprechend auf das BIST-Startsignal wird parallel unter Steuerung der lokalen BIST-Controller die einzelnen funktionalen Blöcke dem Block-BIST unterzogen, um die in der Figur 2 schraffierten Restlogiken 8a, 8b, 8c zu testen. Nach Ablauf des unter Figur 1 beschriebenen Block-BISTs liegt in jedem ersten Signatur-Register 23a, 23b, 23c eine blockspezifische Signatur vor, die möglicherweise vorhandene Fehler in den einzelnen Restlogiken 8a, 8b, 8c aufzeigt.

Bezugnehmend auf die Figuren 3 und 4 wird nun der zweite Schritt des erfindungsgemäßen BIST-Verfahrens, der als Verbindungs-BIST bezeichnet wird, beschrieben. Bei diesem Schritt werden auf ASIC-Ebene global alle Verbindungen zwischen den Blöcken 2a, 2b, 2c und die bei dem Block-BIST nicht erfaßten Teile, nämlich die Eingangslogiken 6a, 6b, 6c und Ausgangslogiken 7a, 7b, 7c getestet. Es ist anzumerken, dass im Rahmen des Verbindungs-BISTs begrifflich die Eingangs- und Ausgangslogiken den Verbindungen zwischen den Blöcken zugewiesen sind. Für diesen Schritte werden die Rollen der TMG 14a, 14b, 14c und der TAA 18a, 18b, 18c unter Steuerung des globalen BIST-Controllers vertauscht. Genauer gesagt, dient der TAA 18b des ersten Schrittes (Block-BIST) im zweiten Schritt (Connection-BIST) als TMG 118b und der Test-Muster-Generator 14b aus dem ersten Schritt dient als Test-Antwort-Auswerter 114b im zweiten Schritt.

Figur 3 zeigt eine ähnliche Ansicht eines Teils des ASICs 1, wie in der Figur 1. Sie zeigt jedoch die Konfiguration des Blocks 2b für den Verbindungs-BIST. Gleiche Bezugszeichen der Figuren 1 und 3 kennzeichnen die selben Elemente.

Ausgangsseitig werden die Scan-Ketten-Ausgangs-Zellen 20b wiederum zu einem Schieberegister 18b, im bevorzugten Ausführungsbeispiel wiederum ein LFSR 18b, zusammengeschaltet. Auf Anweisung des globalen BIST-Controllers 24 (siehe Figuren 2 und 4) dienen sie in diesem Fall jedoch als TMG 18b und geben Testdaten in die Ausgangslogik 7b ein, von wo aus die Testdaten über die funktionalen Ausgänge 4b und Verbindungsleitungen 26 (siehe Figur 4) gegebenenfalls zu den funktionalen Eingängen 3c eines nachfolgenden funktionalen Blocks 2c gelangen, um dort nachfolgend in Eingangslogik 6c und Scan-Ketteneingangs-Flip-Flops 16c des Blocks 2c zu gelangen.

Eingangsseitig, gelangen Testdaten von dem TMG 18a eines vorhergehenden funktionalen Blocks 2a über Verbindungsleitungen 27 (siehe Figur 4) zu den funktionalen Eingängen 3b des Blocks 2b. Diese Daten durchlaufen die Eingangslogik 6b und gelangen so in die Scan-Ketteneingangs-Flip-Flops 16b. Die Scan-Ketteneingangs-Flip-Flops 16b bilden jedoch auf Anweisung des globalen BIST-Controllers 24 im Verbindungs-BIST den TAA 14b. Nach Übernahme durch den TAA 114b und einer gegebenenfalls durchgeführten Komprimierung werden die Testdaten in ein zweites Signatur-Register 28b eingegeben. Die Signatur in dem zweiten Register zeigen Fehler, die möglicherweise in den Verbindungen 26 und 27 oder anderen Elementen, wie der Eingangs- und Ausgangslogik, sowie den funktionalen Eingängen und Ausgängen vorhanden sind, auf. Bei Gatter 124b ist wiederum der Einspeisepunkt der maximalperiodischen Rückkopplung des LSFR angedeutet.

Wie bereits bezüglich des Block-BISTs ausgeführt, werden im bevorzugten Ausführungsbeispiel LFSRs für die Schieberegister 114b und 118b eingesetzt, was einen separaten Testvektorgenerator überflüssig macht. Bei einem anderen Ausführungsbeispiel wird der Testmustergenerator 22b an das Schieberegister 118b gekoppelt um den TMG für den Verbindungs-BIST zu bilden. Bei einer Verwendung des Testvektorgenerators für beide BIST-Schritte ist anzumerken, dass bei dem Verbindungs-BIST eine einfache Stimulierung (weniger Pattern wegen der geringeren Logik-Tiefe) reichen würde.

Bezugnehmend auf die Figur 4 wird nun das Zusammenspiel des Verbindungs-BISTs auf ASIC-Ebene beschrieben. Nach Abschluß des ersten Schrittes, gibt die Reset-Logik 25 erneut einen Reset-Befehl an die lokalen BIST-Controller 12a, 12b, 12c aus, um die funktionalen Blöcke 2a, 2b, 2c zurückzusetzen bzw. zu reseten. Des Weiteren gibt der globale BIST-Controller 24 erneut ein BIST-Start-Signal an die lokalen BIST-Controller 12a, 12b, 12c aus, um diese erneut zu veranlassen, die jeweiligen Schieberegister, zu bilden. Der globale BIST-Controller 24 stellt dabei jedoch sicher, dass der TAA- und der TMG-Betrieb dynamisch umgeschaltet werden. Somit können alle Verbindungen zwischen den funktionalen Blöcken inclusive der Eingangs- und Ausgangs-Logiken 6a, 6b, 6c, 7a, 7b, 7c parallel zueinander getestet werden. Am Ende des Verbindungs-BISTs befinden sich die Signaturen, die gegebenenfalls Fehler in den Verbindungen aufzeigen, in den zweiten Signatur-Registern 28a, 28b, 28c.

Abschließend werden in dem globalen BIST-Controller 24 alle Signaturen der zwei BIST-Schritte aus den ersten und zweiten Signatur-Registern 23a, 23b, 23c, 28a, 28b, 28c gesammelt und eine daraus resultierende BIST-Gesamt-Signatur für den ASIC 1 gebildet. Diese BIST-Gesamtsignatur kann nun für eine externe Fehleranalyse ausgegeben werden. Alternativ könnte die BIST-Gesamtsignatur mit einer vorgegebenen Sequenz verglichen werden, um lediglich das Vorhandensein oder nicht-Vorhandensein eines Fehlers aufzuzeigen.

Wie in Figur 2 und 4 durch Kästchen 41 angedeutet, werden während der Durchführung des kompletten BISTs die ASIC Pins 5 vom Rest des ASIC entkoppelt, d.h. es werden für die ASIC-Eingänge Maskierungen und "Sichere"-Werte für die ASIC-Ausgänge vorgesehen um eine Störung des BISTs, aber auch eine mögliche Beschädigung durch Kurzschlüsse zu vermeiden.

Obwohl im obigen Ausführungsbeispiel das Sammeln der Signaturen der zwei Schritte des BISTs über zwei separate Signaturregister 23b, 28b erfolgt, ist es gemäß einem anderen Ausführungsbeispiels vorstellbar, das jeder Block lediglich ein einzelnes Register aufweist. In diesem Fall werden nach dem Block-BIST alle Einzelsignaturregister vom globalen BIST-Controller ausgelesen, der die ersten Signaturen speichert. Die zweiten Signaturen, die durch den Verbindungs-BIST gewonnen werden, werden dann zunächst ebenfalls in den Einzelsignaturregistern gespeichert und dann durch den globalen BIST-Controller ausgelesen, der aus den ersten und den zweiten Signaturen eine Gesamtsignatur erzeugt, oder wie oben beschrieben einen Vergleich mit einer vorgegebenen Signatur durch führt.

Weiterhin ist bezüglich der Signaturregister 23b, 28b anzumerken, dass es dem Fachmann überlassen bleibt, wie die Signatur aus den jeweiligen Schieberegistern übernommen wird. In den Figuren 1 und 3 ist eine serielle Übernahme angedeutet. Es ist zum Beispiel aber auch eine parallele Übernahme und gleichzeitiger Komprimierung möglich.

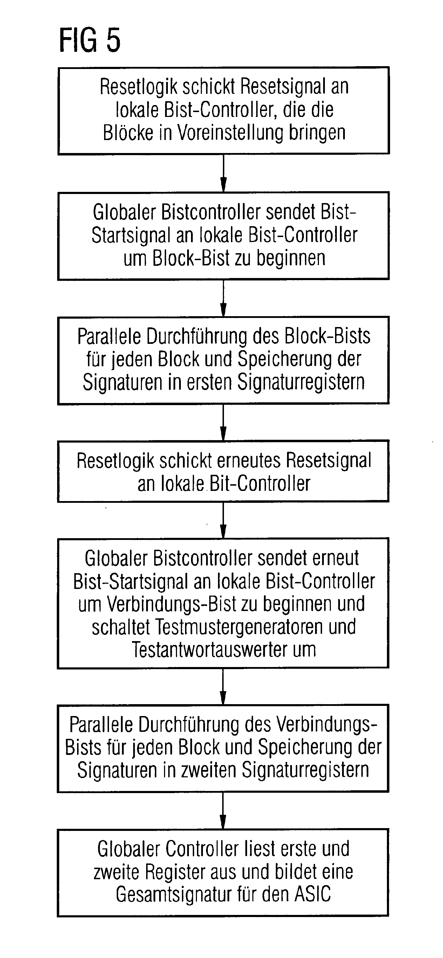

In der Figur 5 ist ein Flussdiagram, das einen Überblick über den Ablauf des erfindungsgemäßen BIST-Verfahrens des bevorzugten Ausführungsbeispiels zeigt.

Durch das Vorsehen des oben beschriebenen erfindungsgemäßen BIST-Verfahrens und eines elektronischen Bausteins 1, der dieses Verfahren durchführen kann, ergeben sich die folgenden Vorteile: Für die Einspeisung der Testdaten in die Restlogiken 8a, 8b, 8c wird zumindest teilweise, keine zusätzliche Logik erfordert, sondern die vorhandenen Eingangs-Flip-Flops 9a, 9b, 9c werden dafür mitverwendet. Die Auswertung der Testdaten durch den TAA 114b, 18b geschieht auch teilweise durch die bereits in der Schaltung vorhandenen Ausgangs-Flip-Flops 10a, 10b, 10c. Weiterhin kann der TAA auch als TMG 118 fungieren und umgekehrt, was die Anzahl der nötigen zusätzlichen Elemente für die Durchführung des BISTs reduziert. Schlußendlich wird das parallel stattfindende Verfahren des Block-BISTs um die Vollständigkeit des "Gesamt-BISTs"-Verfahrens bezüglich der Abdeckung der Verbindungen erweitert.

Generell kann die zuvor beschriebene Erfindung in allen integrierten Schaltungen, aber insbesondere in ASICs angewendet werden. Diese Art von "Design-for-Tests" bietet vor allem bei komplexen ASICs (hohe Gatterzahl, mehrere Taktdomänen) während dem Design den Vorteil der Überschaubarkeit und somit der Reduzierung der Fehlerwahrscheinlichkeit ohne Einbuße der Testabdeckung. Weiterhin könnten Anbieter von computer-aidedengineering-tools die Idee nutzen um ein Design automatisch so zu modifizieren, dass damit die angesprochenen Probleme gelöst werden.

## Patentansprüche

1. Verfahren zum Testen eines elektronischen Bausteins (1) mit in funktionale Blöcke (2a, 2b, 2c) zusammengefasste integrierte Schaltkreise, wobei die funktionalen Blöcke (2a, 2b, 2c) untereinander Verbindungen (26, 27) und eine jeweilige Restlogik (8a, 8b, 8c) aufweisen,
**gekennzeichnet durch** folgende Verfahrensschritte:
Testen der Restlogiken (8a, 8b, 8c) der funktionalen Blöcke (2a, 2b, 2c) **durch** Eingabe von Testdaten in die Restlogiken (8a, 8b, 8c) und Ausgeben einer ersten Signatur für jeden Block,
Testen der Verbindungen zwischen den Blöcken (2a, 2b, 2c) untereinander **durch** Übermittlung von Testdaten über die Verbindungen (26, 27) und ausgeben einer zweiten Signatur.

2. Verfahren nach Anspruch 1,
**dadurch gekennzeichnet,**
**dass** die ersten und zweiten Signaturen bei einem globalen Testcontroller (24) gesammelt und eine Gesamtsignatur für den Baustein (1) erzeugt wird.

3. Verfahren nach einem der vorherigen Ansprüche,
**dadurch gekennzeichnet,**
**dass** das Testen der Restlogiken (8a, 8b, 8c) der jeweiligen Blöcke (2a, 2b, 2c) parallel zueinander durchgeführt wird.

4. Verfahren nach einem der vorherigen Ansprüche,
**dadurch gekennzeichnet,**
**dass** das Testen der Verbindungen parallel zueinander durchgeführt wird.

5. Verfahren nach einem der vorherigen Ansprüche,
**dadurch gekennzeichnet,**
**dass** das Testen der Verbindungen, das Testen von Eingangsund Ausgangslogiken (6a, 6b, 6c, 7a, 7b, 7c) mit einschließt.

6. Verfahren nach einem der vorherigen Ansprüche,
**dadurch gekennzeichnet,**
**dass** jeder funktionale Block (2a, 2b, 2c) Scan-Ketteneingangs-Flipflops (16b) und Scan-Kettenausgangs-Flipflops (20b) aufweist, wobei für das Testen der Restlogiken (8a, 8b, 8c) und das Testen der Verbindungen die Scan-Ketteneingangs-Flipflops (16b) und Scan-Kettenausgangs-Flipflops (20b) durch einen lokalen Controller (12a, 12b, 12c) jeweils zu einem Schieberegister (14a ,14b ,14c, 18a, 18b, 18c) zusammengeschaltet werden.

7. Verfahren nach Anspruch 5,
**dadurch gekennzeichnet,**
**dass** die Scan-Ketteneingangs-Flipflops (16b) und Scan-Kettenausgangs-Flipflops (20b) jeweils zu einem Linear-Feedback-Shift-Register (14a ,14b ,14c, 18a, 18b, 18c) zusammengeschaltet werden.

8. Verfahren nach Anspruch 5,
**dadurch gekennzeichnet,**
**dass** die Scan-Ketteneingangs-Flipflops (16b) und/oder Scan-Kettenausgangs-Flipflops (20b) mit einem Testvektorgenerator (22b) gekoppelt werden um Testdaten für die Schieberegister (14a ,14b ,14c, 18a, 18b, 18c) vorzusehen.

9. Verfahren nach einem der vorherigen Ansprüche,
**dadurch gekennzeichnet,**
**dass** für das parallele Testen der Restlogiken (8a, 8b, 8c) die Scan-Ketteneingangs-Flipflops (16b) als Testmustergenerator und die Scan-Kettenausgangs-Flipflops (20b) als Testantwortauswerter dienen und
für das Testen der Verbindungen (26, 27) die Scan-Ketteneingangs-Flipflops (16b) als Testantwortauswerter (114b) und die Scan-Kettenausgangs-Flipflops (20b) als Testmustergenerator (118b) dienen.

10. Elektronischer Baustein (1) mit in funktionale Blöcke (2a, 2b, 2c) zusammengefasste integrierte Schaltkreise, wobei die funktionalen Blöcke (2a, 2b, 2c) untereinander Verbindungen (26, 27) und jeweils eine Restlogik (8a, 8b, 8c) aufweisen,
**dadurch gekennzeichnet,**
**dass** jeder funktionale Block (2b) ein erstes und ein zweites Schieberegister (14b, 18b) aufweist, wobei das erste Schieberegister (14b) zum Testen der Restlogik (8b) Testdaten bereitstellt, die nach Durchlaufen der Restlogik (8b) vom zweiten Schieberegister (18b) aufgenommen werden und als erste Signatur vorgesehen werden, und
wobei zum Testen der Verbindungen (26, 27) das zweite Schieberegister (18b)Testdaten zum Testen der Verbindungen (26, 27) bereitstellt, die von dem ersten Schieberegister nach Durchlaufen der Ausgangs- und Eingangslogik (7b, 6b) aufgenommen und als zweite Signatur vorgesehen werden.

11. Elektronischer Baustein nach einem der vorhergehenden Ansprüche,
**dadurch gekennzeichnet,**
**dass** durch einen globalen Testcontroller (24), der die ersten und zweiten Signaturen von den funktionalen Blöcken (2a, 2b, 2c) zugeführt erhält und eine Gesamtsignatur für den Baustein (1) mit den ersten und zweiten Signaturen erzeugt.

12. Elektronischer Baustein (1) nach einem der vorhergehenden Ansprüche,
**dadurch gekennzeichnet,**
**dass** jeder funktionale Block (2a, 2b, 2c) einen lokalen Testcontroller (12a, 12b, 12c) aufweist, der das erste und das zweite Schieberegister (14b,18b) steuert.

13. Elektronischer Baustein (1) nach einem der vorhergehenden Ansprüche,
**dadurch gekennzeichnet,**
**dass** der globale Testcontroller (24) mit den lokalen Testcontrollern (12a, 12b, 12c) der funktionalen Blöcke (2a, 2b, 2c) verbunden ist und ein Startsignal an diese sendet, wobei die lokalen Testcontroller (12a, 12b, 12c) in Abhängigkeit des Startsignal die ersten und zweiten Schieberegister (14b,18b) dynamisch in den Schiebe- und Übernahmemodus schalten und den Test des elektronischen Bausteins (1) durchführen.

14. Elektronischer Baustein (1) nach einem der vorhergehenden Ansprüche,
**gekennzeichnet durch** eine Reset-Logik (25), die mit den lokalen Testcontrollern (12a, 12b, 12c) der funktionalen Blöcke (2a, 2b, 2c) verbunden ist und ein Reset-Signal (25) an diese sendet, wobei die lokalen Testcontroller (12a, 12b, 12c) ansprechend auf das Reset-Signal den funktionalen Block (2a, 2b, 2c) zurücksetzt.

15. Elektronischer Baustein (1) nach einem der vorhergehenden Ansprüche,
**dadurch gekennzeichnet,**
**dass** das Testen der Restlogiken (8a, 8b, 8c) der einzelnen Blöcke (2a, 2b, 2c) parallel durchgeführt wird.

16. Elektronischer Baustein (1) nach einem der vorhergehenden Ansprüche,
**dadurch gekennzeichnet,**
**dass** das Testen der Verbindungen (26, 27) parallel durchgeführt wird.

17. Elektronischer Baustein (1) nach einem der vorhergehenden Ansprüche,
**dadurch gekennzeichnet,**
**dass** das Testen der Verbindungen (26, 27) das Testen von Eingangs- und Ausgangslogiken (6a, 6b, 6c, 7a, 7b, 7c) der funktionalen Blöcke mit einschließt.

18. Elektronischer Baustein (1) nach einem der vorhergehenden Ansprüche,
**dadurch gekennzeichnet,**
**dass** das erste Schieberegister (14b) Scan-Ketteneingangs-Flipflops (16b) zur Stimulierung von Scan-Eingängen (17b) und das zweite Schieberegister (18b) Scan-Kettenausgangs-Flipflops (20b), die mit Scan-Ausgängen (21b) gekoppelt sind, aufweist.

19. Elektronischer Baustein (1) nach einem der vorhergehenden Ansprüche,
**dadurch gekennzeichnet,**
**dass** die Scan-Ketteneingangs-Flipflops (16b) sowohl bereits für die Bausteinfunktion bereits existierende Eingangs-FFs (9b) als auch zusätzliche Eingangs-FFs (15b) aufweist.

20. Elektronischer Baustein (1) nach einem der vorhergehenden Ansprüche,
**dadurch gekennzeichnet,**
**dass** die Scan-Kettenausgangs-Flipflops (20b) sowohl bereits für die Bausteinfunktion bereits existierende Ausgangs-FFs (10b) als auch zusätzliche Ausgangs-FFs (19b) aufweist.

21. Elektronischer Baustein (1) nach einem der vorhergehenden Ansprüche,
**dadurch gekennzeichnet,**
**dass** das erste und/oder zweite Schieberegister (14b, 18b) mit einem Testvektorgenerator (22b) koppelbar ist.

22. Elektronischer Baustein (1) nach einem der vorhergehenden Ansprüche,
**dadurch gekennzeichnet,**
**dass** das erste und das zweite Schieberegister (14b, 18b) ein Linear Feedback Shift Register (LFSR) ist.
